# EUROPÄISCHE PATENTSCHRIFT

(11) **EP 1 345 477 B1**
(45) Veröffentlichungstag und Bekanntmachung des Hinweises auf die Patenterteilung: **25.04.2007**
(21) Anmeldenummer: 03002773.4
(22) Anmeldetag: 07.02.2003
(51) Int. Cl.: C08G 61/02, H01B 1/12, H05B 33/14

(54) **Polymere auf Basis von Fluoranthen und ihre Verwendung**
Polymers based on fluoranthene and the use thereof
Polymères à base de fluoranthènes et leur utilisation

(30) Priorität: 15.03.2002 DE 10211648
(43) Veröffentlichungstag der Anmeldung: 17.09.2003
(73) Patentinhaber: BASF Aktiengesellschaft, 67056 Ludwigshafen (DE)
(72) Erfinder: Schwalm, Reinhold, Dr., 67157 Wachenheim (DE); Heischkel, Yvonne, Dr., 68199 Mannheim (DE); Weiss, Horst, Dr., 67141 Neuhofen (DE)

(56) Entgegenhaltungen:
- EP-A- 0 329 322
- EP-A- 0 808 855
- WO-A-00/46321
- DE-A- 4 414 693
- GB-A- 2 360 291
- SU-A- 412 205
- US-A- 5 777 070
- US-A1- 2001 026 878
- US-B1- 6 169 163
- US-B1- 6 353 072

## Beschreibung

Die vorliegende Erfindung betrifft Polymere, enthaltend Wiederholungseinheiten der allgemeinen Formel I 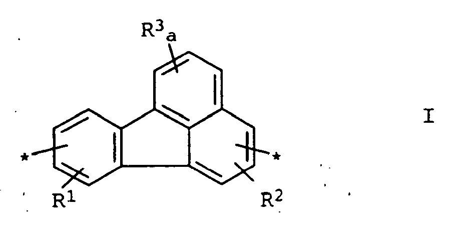 in denen die Variablen wie folgt definiert sind:
a eine ganze Zahl von 0 bis 3,
R¹, R², R³ gleich oder verschieden und unabhängig voneinander gewählt aus Wasserstoff, C₁-C₂₀-Alkyl,
   C₁-C₂₀-Alkyl, das ein oder mehrere Si, N, P, O- oder S-Atome enthält, C₆-C₃₀-Aryl, bevorzugt C₆-C₁₄-Aryl, C₄-C₁₄-Heteroaryl mit mindestens einem S- oder N-Atom, -N(C₆-C₁₄-Aryl)₂,
Y¹, wobei Y¹ gleich oder verschieden sein können und gewählt werden aus -CH=CH₂, (E)- oder (Z)-CH=CH-C₆H₅, Acryloyl, Methacryloyl, Methylstyryl, O-CH=CH₂ oder Glycidyl, 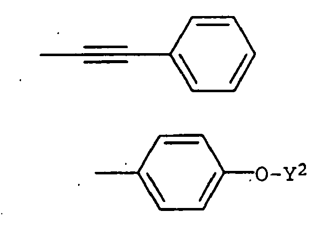
wobei Y² gewählt wird aus -CH=CH₂, (E)- oder (Z)-CH=CH-C₆H₅, Acryloyl, Methacryloyl, Methylstyryl, -O-CH=CH₂ oder Glycidyl und wobei eine oder mehrere Gruppen Y¹ oder Y² miteinander vernetzt sein können.

Polymere mit elektrischer Leitfähigkeit sind von steigender wirtschaftlicher und technischer Bedeutung, beispielsweise auf dem Gebiet der elektroelektrolumineszierenden Dioden. Diese lassen sich in vielfältiger Weise einsetzen, beispielsweise als Displays in Mobiltelefonen oder für Bildschirme im Computerbereich.

Organische elektroelektrolumineszierende Dioden enthalten üblicherweise eine Kathode und eine Anode, die durch einen, besser mindestens zwei Filme aus einem organischen Material separiert sind. Die Filme sind typischerweise nicht dicker als 0,2 µm. Vorteilhaft sind die zwei Elektroden aus unterschiedlichen Materialien, deren Leitungsband oder Valenzband dicht bei den Potenzialen der HOMO- und LUMO-Energieniveaus der betreffenden Polymeren liegen. Mindestens eine der Elektroden - Kathode oder Anode - besteht aus einem Metallfilm oder einem Metalloxidfilm, der etwa 0,2 µm dick ist, und ist optisch transparent.

Eine Übersicht über organische elektroelektrolumineszierende Dioden wurde beispielsweise von M.T. Bernius *et al*. in Adv. Mat. 2000, 12, 1737 publiziert. Die Anforderungen an die Polymeren ist dabei hoch, und es gelingt den bekannten Materialien üblicherweise nicht, allen gestellten Anforderungen zu genügen. Dabei hat es sich gezeigt, dass nicht nur die Wahl des Monomers von großer Bedeutung für die Einsetzbarkeit der Polymeren ist.

Polymere auf Basis von Fluoranthen und gegebenenfalls anderen (Co)monomeren sind als solche bekannt. Sie werden üblicherweise durch elektrochemische Kupplungsreaktionen hergestellt, s. beispielsweise R.J. Waltman et al., J. Electrochem. Sci. 1985, 132, 631. Man beobachtet die Bildung von strukturell sehr uneinheitlichen Polymeren mit hoher Polydispersität und niedrigen Glasübergangstemperaturen.

Aus US 5,281,489 ist die Verwendung von monomerem Fluoranthen in organischen elektroelektrolumineszierenden Dioden bekannt. Monomeres Fluoranthen kann aber unter Anwendungsbedingungen migrieren. Die Schicht aus monomerem Fluoranthen ist nicht stabil, woraus eine geringe Lebensdauer der Dioden resultiert.

Aus US 6,127,516 sind elektrochrome Materialien auf Basis von 7,10-Diphenylacenaphthofluoranthen bekannt, die sich durch Abscheidung auf Elektrodenoberflächen herstellen lassen. Die Molekulargewichtsverteilung ist üblicherweise zu breit für Anwendungen in Dioden.

Aus US 5,777,070 ist ein Verfahren zur Herstellung von konjugierten Polymeren bekannt, das auf der Suzuki-Kupplung von Monomeren, die interne Gruppen beispielsweise vom Typ Ethylen, Acetylen, Phenylen, Fluoren, Fluoranthen, Anthracen, Phenanthren und andere beruht und in Gegenwart eines Phasentransferkatalysators durchgeführt wird. Beispielhaft wird die Suzuki-Kupplung von Monomeren auf Basis von Fluoren ausgeführt. Die Lebenszeit elektrolumineszierender Dioden mit Polyfluorenen ist jedoch noch zu verbessern.

Aus WO 00/46321 sind elektrisch leitfähige Fluorencopolymere bekannt, die mindestens 10 mol-% 9-monosubstituierte und/oder 9,9-disubstituierte Fluoreneinheiten tragen.

Es bestand die Aufgabe, neue elektrisch leitfähige Polymere bereitzustellen, die sich zur Verwendung in Dioden eignen. Weiterhin bestand die Aufgabe, ein Verfahren zur Herstellung der erfindungsgemäßen Polymere bereitzustellen. Schließlich bestand die Aufgabe, neue Verwendungen und Applikationsmethoden für die erfindungsgemäßen Polymere bereitzustellen.

Demgemäß wurden die eingangs definierten Polymere gefunden.

Die Nomenklatur der Floranthene im Sinne der vorliegenden Erfindung erfolgt nach dem unten stehenden Schema:

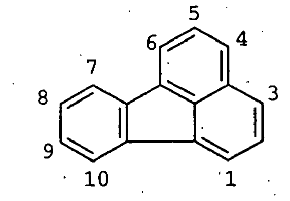

In Formel I sind die Variablen wie folgt definiert.
a ist eine ganze Zahl von 0 bis 3, bevorzugt 0 oder 1 und ganz besonders bevorzugt 0.
R¹, R², R³ sind gleich oder verschieden und unabhängig voneinander gewählt aus Wasserstoff, C₁-C₂₀-Alkyl, wie Methyl, Ethyl, n-Propyl, iso-Propyl, n-Butyl, iso-Butyl, sec.-Butyl, tert.-Butyl, n-Pentyl, iso-Pentyl, sec.-Pentyl, neo-Pentyl, 1,2-Dimethylpropyl, iso-Amyl, n-Hexyl, iso-Hexyl, sec.-Hexyl, n-Heptyl, iso-Heptyl n-Octyl, n-Decyl, n-Dodecyl oder n-Octadecyl; bevorzugt C₁-C₁₂-Alkyl wie Methyl, Ethyl, n-Propyl, iso-Propyl, n-Butyl, iso-Butyl, sec.-Butyl, tert.-Butyl, n-Pentyl, iso-Pentyl, sec.-Pentyl, neo-Pentyl, 1,2-Dimethylpropyl, iso-Amyl, n-Hexyl, iso-Hexyl, sec.-Hexyl oder n-Decyl, besonders bevorzugt C₁-C₄-Alkyl wie Methyl, Ethyl, n-Propyl, iso-Propyl, n-Butyl, iso-Butyl, sec.-Butyl und tert.-Butyl;
   C₁-C₂₀-Alkyl, das ein oder mehrere Si, N, P, O- oder S-Atome enthält, beispielsweise -CH₂-CH₂-OCH₃, -[CH₂-CH₂]₂-OCH₃, - [CH₂-CH₂]₃-OCH₃, -[CH₂-CH₂]₃-OC₂H₅, -[CH₂-CH₂]₃-O-n-C₃H₇, -[CH₂-CH₂]₃-O-i-C₃H₇, -[CH₂-CH₂]₃-n-OC₄H₉, -CH₂-CH₂-SCH₃, -CH₂-CH₂-N(CH₃)₂, -CH₂-CH-(OCH₃)₂, -CH₂-CH₂-P(CH₃)₂, -CH₂-CH₂-Si(CH₃)₃, -CH₂-CH₂-OSi(CH₃)₃;
C₆-C₃₀-Aryl, beispielsweise Phenyl, 1-Naphthyl, 2-Naphthyl, 1-Anthryl, 2-Anthryl, 9-Anthryl, 1-Phenanthryl, 2-Phenanthryl, 3-Phenanthryl, 4-Phenanthryl und 9-Phenanthryl, 9-Fluorenyl oder 2,8-Indenofluorenyl, bevorzugt C₆-C₁₄-Aryl, beispielsweise Phenyl, 1-Naphthyl, 2-Naphthyl, 1-Anthryl, 2-Anthryl, 9-Anthryl, 1-Phenanthryl, 2-Phenanthryl, 3-Phenanthryl, 4-Phenanthryl und 9-Phenanthryl, 9-Fluorenyl, besonders bevorzugt Phenyl, 1-Naphthyl und 2-Naphthyl, besonders bevorzugt Phenyl;
C₄-C₁₄-Heteroaryl mit einem oder mehreren S- oder N-Atomen, beispielsweise *N*-Pyrrolyl, Pyrrol-2-yl, Pyrrol-3-yl, *N*-Imidazolyl, 2-Imidazolyl, 4-Imidazolyl, 1,2,4-Triazol-3-yl, 1,2,4-Triazol-4-yl, 2-Pyridyl, 3-Pyridyl, 4-Pyridyl, 3-Pyridazinyl, 4-Pyridazinyl, 2-Pyrimidinyl; 4-Pyrimidinyl, 5-Pyrimidinyl, N-Indolyl und N-Carbazolyl;
   -N(C₆-C₁₄-Aryl)₂, wobei C₆-C₁₄-Aryl gleich oder verschieden sein kann und wie oben definiert ist;
eine oder mehrere Gruppen Y¹, wobei Y¹ gleich oder verschieden sein können und gewählt werden aus -CH=CH₂, (E)- oder (Z)-CH=CH-C₆H₅, Acryloyl, Methacryloyl, α-Methylstyryl oder para-Methylstyryl, -O-CH=CH₂ oder Glycidyl, 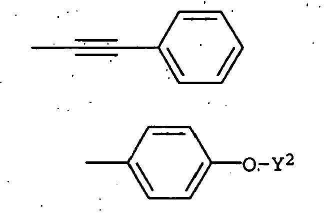
wobei Y² gewählt wird aus Acryloyl, Methacryloyl, α-Methylstyryl oder para-Methylstyryl, O-CH=CH₂ oder Glycidyl, und wobei eine oder mehrere Gruppen Y¹ oder Y² miteinander vernetzt sein können.

Bevorzugt sind Polymere, enthaltend Wiederholungseinheiten der allgemeinen Formel I a
in denen a gleich 0 oder 1 ist und in denen die übrigen Variablen wie oben definiert sind. Ganz besonders bevorzugt ist a gleich 0 und R¹ und R² jeweils Wasserstoff.

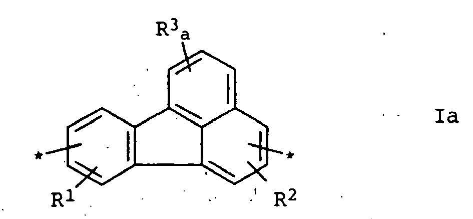

Unter Polymeren im Sinne der vorliegenden Erfindung werden auch solche Verbindungen verstanden, die lediglich 2 Wiederholungseinheiten der allgemeinen Formel I bzw. I a aufweisen und die an den jeweiligen Enden durch je einen Rest abgesättigt sind. Unter Polymeren im Sinne der vorliegenden Erfindung werden ferner auch solche Verbindungen verstanden, die eine Wiederholungseinheit der allgemeinen Formel I bzw. I a aufweisen sowie mindestens eine Comonomereinheit, die mit der Wiederholungseinheit I bzw. I a ein konjugiertes System bildet. Beispiele sind para-Phenyleneinheiten, (E)- oder (Z)-Ethyleneinheiten, Acetyleneinheiten, 1,4-Naphthyleneinheiten, 1,5-Naphthyleneinheiten, 1,4-Anthryleneinheiten, 9,10-Anthryleneinheiten, weiterhin C₄-C₁₄-Heteroaryleneinheiten mit N, S und/oder O als Heteroatomen, beispielsweise 2,5-Thiopheneinheiten, wobei die Thiopheneinheiten vorzugsweise in 3- und 4-Position substituiert sind, 2,7-Carbazolyleneinheiten, 2,5-Pyridyleneinheiten, wobei die Comonomereinheiten auch zusätzliche Substituenten tragen können, beispielsweise Cyano-, C₁-C₆-Alkoxy, Di-C₁-C₆-Alkylamino-Substituenten. Weitere geeignete Comonomereinheiten sind

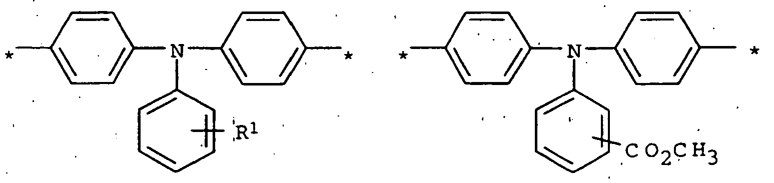

Die erfindungsgemäßen Polymere enthalten zwischen 1 und 10 Wiederholungseinheiten der allgemeinen Formeln I oder I a, bevorzugt 2 bis 4, besonders bevorzugt 2 bis 3 Wiederholungseinheiten der allgemeinen Formeln I oder I a. Die erfindungsgemäßen Polymere weisen für den Fall, dass sie lediglich 1 wiederholungseinheit der allgemeinen Formeln I oder I a enthalten, 1 bis 300 Comonomereinheiten, und für den Fall, dass sie mindestens zwei Wiederholungseinheiten der allgemeinen Formeln I oder I a aufweisen, 0 bis 300, bevorzugt bis 50, besonders bis 10 CoWiederholungseinheiten auf.

Die Polydispersität M_{w}/Mₙ der erfindungsgemäßen Polymere beträgt vorzugsweise 1,1 bis 3,5.

Die Polymere sind an den Enden üblicherweise abgesättigt mit je einem Rest, ausgewählt aus Wasserstoff, C₆-C₁₄-Aryl und C₄-C₁₄-Heteroaryl, wobei die Reste wie oben stehend definiert sind.

Ein weiterer Aspekt der vorliegenden Erfindung ist ein Verfahren zur Herstellung der erfindungsgemäßen Polymere. Die erfindungsgemäßen Polymere werden vorzugsweise durch Reaktionen der metallorganischen Chemie hergestellt, beispielsweise durch Yamada-Kupplung oder durch Suzuki-Reaktion. Bevorzugt ist ein Verfahren, in dem man aus geht von Monomeren der allgemeinen Formel II 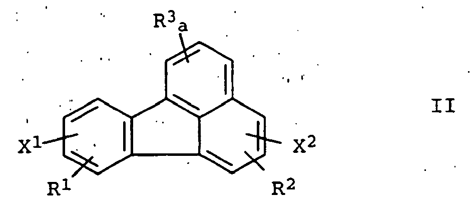 und insbesondere der Formel II a, 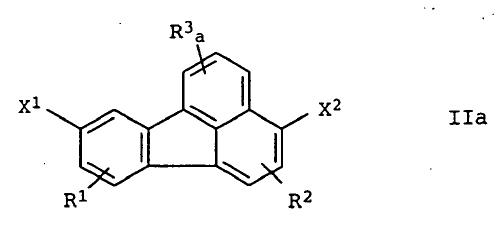 in denen die Variablen wie folgt definiert sind:
X¹ und X² gleich oder verschieden sind und gewählt aus
Halogen, beispielsweise Chlor, Brom oder Iod, insbesondere Chlor oder Brom, oder verestertes Sulfonat wie beispielsweise para-Toluolsulfonat (Tosylat), Triflat (CF₃-SO₃-), para-Nitrophenylsulfonat ("Nosylat"), para-Bromsulfonat ("Brosylat"), insbesondere Triflat;
   borhaltige Reste der Formel -B(O-[C(R⁶)₂]ₙ)-O), wobei
R⁶ gleich oder verschieden ist und ausgewählt aus Wasserstoff oder C₁-C₂₀-Alkyl, wie Methyl, Ethyl, n-Propyl, iso-Propyl, n-Butyl, iso-Butyl, sec.-Butyl, tert.-Butyl, n-Pentyl, iso-Pentyl, sec.-Pentyl, neo-Pentyl, 1,2-Dimethylpropyl, iso-Amyl, n-Hexyl, iso-Hexyl, sec.-Hexyl, n-Heptyl, iso-Heptyl n-Octyl, n-Decyl, n-Dodecyl oder n-Octadecyl; bevorzugt C₁-C₁₂-Alkyl wie Methyl, Ethyl, n-Propyl, iso-Propyl, n-Butyl, iso-Butyl, sec.-Butyl, tert.-Butyl, n-Pentyl, iso-Pentyl, sec.-Pentyl, neo-Pentyl, 1,2-Dimethylpropyl, iso-Amyl, n-Hexyl, iso-Hexyl, sec.-Hexyl oder n-Decyl, besonders bevorzugt C₁-C₄-Alkyl wie Methyl, Ethyl, n-Propyl, iso-Propyl, n-Butyl, iso-Butyl, sec.-Butyl und tert.-Butyl, ganz besonders bevorzugt Methyl;
n eine ganze Zahl von 2 bis 10, vorzugsweise 2 bis 5 ist.

Ganz besonders bevorzugt sind borhaltige Reste der Formel -B(O-[C(CH₃)₂]₂)-O).

Bei der Durchführung des erfindungsgemäßen Verfahrens geht man entweder so vor, dass man ein Monomer der allgemeinen Formel II einsetzt und in diesem X¹ wählt aus Halogen und veresterem Sulfonat und X² aus borhaltigen Resten. Man kann auch so vorgehen, dass man mindestens zwei verschiedene Monomere der allgemeinen Formel II einsetzt, wobei ein Monomer zwei Halogenatome oder zwei veresterte Sulfonatgruppen oder ein Halogenatom und eine veresterte Sulfonatgruppe aufweist und das andere Monomer zwei borhaltige Reste -B(O-[C(R⁶)₂]ₙ)-O) aufweist. In diesem Fall ist zu beachten, dass das Molverhältnis aus der Summe von Halogen und verestertem Sulfonat einerseits und borhaltigen Resten anderseits zwischen 0,8 : 1 und 1,2 zu 1 liegt.

Die Polymerisation führt man vorzugsweise in Gegenwart einer Nikkel- oder Palladiumverbindung durch, die insbesondere in der Oxidationsstufe 0 vorliegen. Ganz besonders bevorzugt ist das kommerziell erhältliche Tetrakis(triphenylphosphan)-Palladium [Pd{P(C₆H₅)₃}₄] sowie kommerziell erhältliche Nickelverbindungen, beispielsweise Ni(C₂H₄)₃, Ni(1,5-Cyclooctadien)₂ "Ni(COD)₂", Ni(1,6-Cyclodecadien)₂, oder Ni(1,5,9-*all-trans*-Cyclododecatrien)₂. Besonders bevorzugt ist Ni[COD]₂. Zur Durchführung der Polymerisation kann man einen Überschuss an P(C₆H₅)₃ beziehungsweise 1,5-Cyclooctadien zugeben. Bei der Durchführung der Polymerisation in Gegenwart von Palladiumverbindungen reichen üblicherweise katalytische Mengen, d.h. 0,1 bis 10 mol-% Pd, bezogen auf Monomer der allgemeinen Formel II bzw. II a. Wünscht man die Polymerisation in Gegenwart von Nickel-Verbindungen durchzuführen, so sind üblicherweise stöchiometrische Mengen an Ni, bezogen auf die Summe an Monomeren der allgemeinen Formel II bzw. II a und' gegebenenfalls Comonomer, erforderlich.

Die Polymerisation führt man üblicherweise in einem organischen Lösemittel durch, beispielsweise Toluol, Ethylbenzol, meta-Xylol, ortho-Xylol, Dimethylformamid DMF, Tetrahydrofuran, Dioxan oder Mischungen der vorstehenden Lösemittel. Das oder die Lösemittel wird vor der Polymerisation nach laboratoriumsüblichen Methoden von Spuren Feuchtigkeit befreit. Die Polymerisation wird üblicherweise unter Schutzgas durchgeführt; geeignet sind Stickstoff oder Edelgase, insbesondere, Argon, oder CO₂.

Üblicherweise führt man die Polymerisation in Gegenwart einer Base durch, beispielsweise sind organische Amine geeignet, besonders geeignet ist Triethylamin, Pyridin oder Collidin.

Man kann die Polymerisation auch in Gegenwart von festen basischen Salzen, beispielsweise Alkalimetallcarbonat oder Alkalimetallbicarbonat, gegebenenfalls in Gegenwart eines Kronenethers wie 18-Krone 6, durchführen. Auch ist es möglich, die Polymerisation als Zweiphasenreaktion mit wässrigen Lösungen von Alkalimetallcarbonat, gegebenenfalls in Gegenwart eines Phasentransferkatalysators, durchzuführen. In diesem Falle ist es nicht nötig, das organische Lösemittel vor der Reaktion von Feuchtigkeit zu befreien.

Üblicherweise dauert die Polymerisation zwischen 10 Minuten bis zu 2 Tagen, vorzugsweise 2 Stunden bis 24 Stunden. Die Druckbedingungen sind unkritisch, bevorzugt ist Atmosphärendruck. Üblicherweise führt man die Polymerisation bei erhöhter Temperatur durch, im Allgemeinen zwischen 80°C und dem Siedepunkt des organischen Lösemittels bzw. Lösemittelgemisches, insbesondere zwischen 100°C und dem Siedepunkt des organischen Lösemittels bzw. Lösemittelgemisches.

Wünscht man Copolymere aus Monomeren der allgemeinen Formel II und den oben bezeichneten Comonomeren herzustellen, so verwendet man als Comonomere die entsprechenden para-Phenylenverbindungen, (E)- oder (Z)-Ethylenverbindungen, Acetylenverbindungen, 1,4-Naphthylenverbindungen, 1,5-Naphthylenverbindungen, 1,4-Anthrylenverbindungen, 9,10-Anthrylenverbindungen und/oder 2,5-Thiophenverbindungen welche die oben bezeichneten Resten X¹ und X² tragen, mit der oben bezeichneten Maßgabe bezüglich der Molverhältnisse aus Halogen und verestertem Sulfonat einerseits und borhaltigen Resten andererseits.

Ein weiterer Aspekt der vorliegenden Erfindung sind Monomere der allgemeinen Formel III, 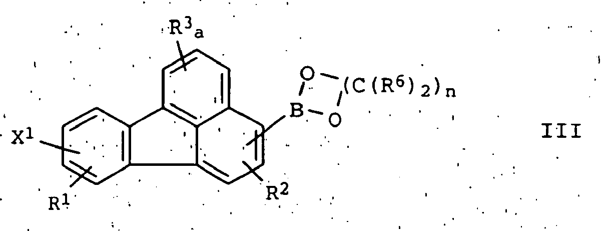 insbesondere der allgemeinen Formel III a 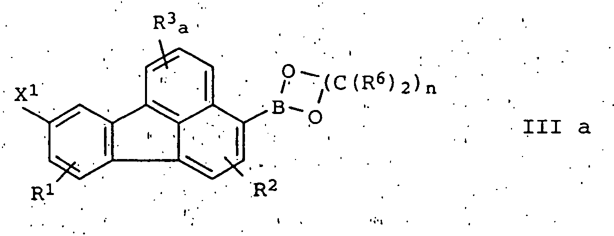 in denen die Variablen wie oben stehend definiert sind. Monomere der allgemeinen Formeln III und insbesondere der Formel III a werden zur Herstellung der erfindungsgemäßen Polymere eingesetzt. Ein weiterer Aspekt der vorliegenden Erfindung ist ein Verfahren zur Herstellung der erfindungsgemäßen Monomere der allgemeinen Formel III und insbesondere III a. Das erfindungsgemäße Verfahren geht aus von Verbindungen der allgemeinen Formel IV bzw. IV a, 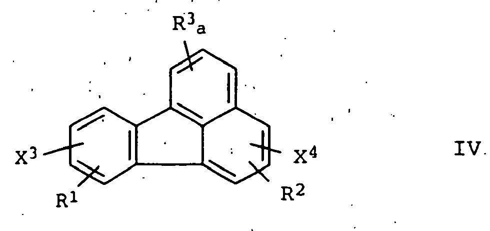 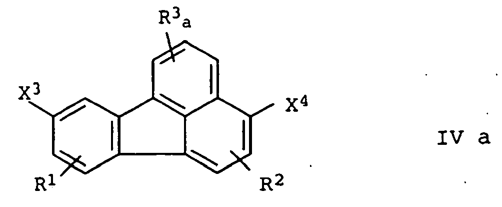 in denen X³ und X⁴ Halogen, insbesondere Chlor oder Brom, oder verestertes Sulfonat, insbesondere Triflat (CF₃-SO₃-), bedeuten.

Zur Durchführung des erfindungsgemäßen Verfahrens werden die Verbindungen der allgemeinen Formel IV und insbesondere der Formel IV a zunächst mit mindestens zwei oder mindestens vier Äquivalenten einer stärken metallorganischen Base einfach bzw. zweifach metalliert und anschließend mit einem beziehungsweise 2 Äquivalenten einer Borverbindung der allgemeinen Formel V 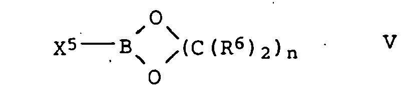 umsetzt, in der die Variablen R⁶ und n wie oben beschrieben definiert sind und X⁵ gewählt wird aus C₁-C₆-Alkoxy wie Methoxy, Ethoxy, n-Propoxy, iso-Propoxy, n-Butoxy, iso-Butoxy, sec.-Butoxy, tert.-Butoxy, n-Pentoxy, iso-Pentoxy, n-Hexoxy und iso-Hexoxy, besonders bevorzugt Methoxy, Ethoxy, n-Propoxy, iso-Propoxy und n-Butoxy. Ganz besonders bevorzugt ist X⁵ iso-Propoxy.

Als Base können die in der Metallorganischen Chemie gängigen Metallalkyle verwendet werden wie beispielsweise Methyllithium, Ethyllithium, n-Butyllithium, sec-Butyllithium, tert.-Butyllithium oder Hexyllithium, weiterhin Grignard-Verbindungen wie beispielsweise Ethylmagnesiumbromid. Als Lösemittel haben sich hochsiedende Lösemittel wie Toluol, ortho-Xylol, meta-Xylol, para-Xylol, Ethylbenzol oder Mischungen derselben als geeignet erwiesen, des Weiteren nichtcyclische oder cyclische Ether wie 1,2-Dimethoxyethan, Tetrahydrofuran, Dioxan oder Diethylether.

Die Metallierung ist im Allgemeinen nach einigen Stunden beendet, sinnvoll ist eine Reaktionsdauer von 1 bis 10 Stunden, bevorzugt sind 2 bis 5 Stunden. Die Temperaturbedingungen sind im Allgemeinen unkritisch, eine Durchführung bei Temperaturen von -90°C bis -20°C hat sich als bevorzugt erwiesen.

Anschließend setzt man die einfach oder zweifach metallierte Verbindung der allgemeinen Formel IV bzw. IV a mit mindestens einem bzw. zwei Äquivalenten einer Borverbindung der allgemeinen Formel V um. Dazu mischt man die beiden Komponenten miteinander in einem geeigneten Lösemittel wie Benzol, Toluol, Ethylbenzol, ortho-Xylol, meta-Xylol oder para-Xylol, Chlorbenzol, Cyclohexan, Acetonitril, Tetrahydrofuran, 1,2-Dimethoxyethan, Dioxan oder Diethylether oder Gemischen derselben. Als Temperaturbereich kommen -100°C bis +150°C in Frage, bevorzugt -78°C bis +100°C. Wichtig ist, dass man die Umsetzung unter Ausschluss von Sauerstoff und Feuchtigkeit durchführt.

Die Druckbedingungen sind im Allgemeinen unkritisch, bevorzugt ist Atmosphärendruck. Bevorzugte Reaktionsdauer ist 10 Minuten bis 2 Tage, bevorzugt 1 Stunde bis 24 Stunden.

Die Aufarbeitung und Reinigung der erfindungsgemäßen Monomere der allgemeinen Formel III bzw. III a kann nach konventionellen Methoden erfolgen, beispielsweise Extraktion, Perforation, Kristallisation, Chromatographie, Umfällen oder Sublimation.

Borverbindungen der allgemeinen Formel V sind leicht synthetisch zugänglich, einige Derivate sind bei Sigma-Aldrich kommerziell erhältlich.

Die Verbindungen der allgemeinen Formel IV bzw. IV a lassen sich durch im Prinzip bekannte Reaktionen oder Reaktionssequenzen aus Fluoranthen bzw. den entsprechenden Fluoranthenderivaten gewinnen. Die Herstellung der ganz besonders bevorzugten Verbindungen IV a.1 und IV a.2 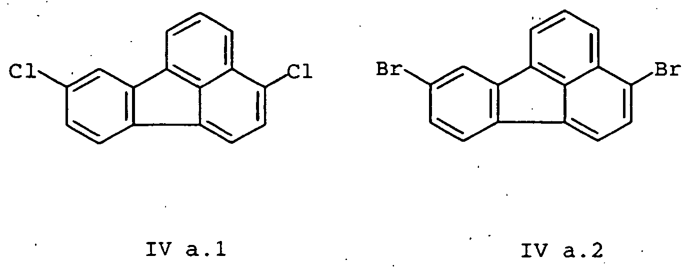 erfolgt beispielsweise durch Chlorierung bzw. Bromierung des unsubstituierten Fluoranthens in beispielsweise Eisessig oder Nitrobenzol mit zwei Äquivalenten Cl₂ bzw. Br₂. Die Darstellung der ganz besonders bevorzugten Verbindungen IV a.3 und IV a.4 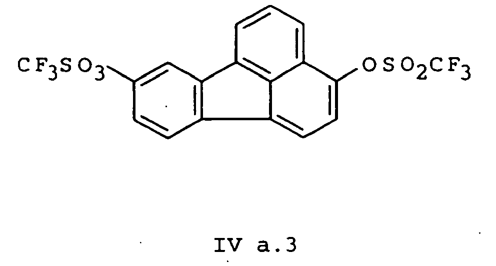 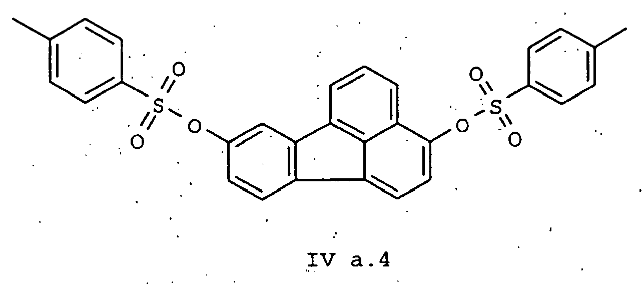 kann beispielsweise durch Dinitrierung von Fluoranthen erfolgen, anschließender Reduktion der Nitrogruppen zu Aminogruppen, Diazotierung der Aminogruppen mit NaNO₂/HCl oder Amylnitrit und Verkochen der Diazoniumsalze und abschließender Umsetzung der phenolischen OH-Gruppen mit CF₃SO₂Cl zum Bis-Triflat IV a.3 bzw. mit para-CH₃-C₆H₄-SO₂Cl zum Bis-Tosylat IV a.4.

Ein weiterer Aspekt der vorliegenden Erfindung ist ein weiteres Verfahren zur Herstellung der erfindungsgemäßen Polymere.

Dazu geht man vorzugsweise so vor, dass man Monomere der allgemeinen Formel VI 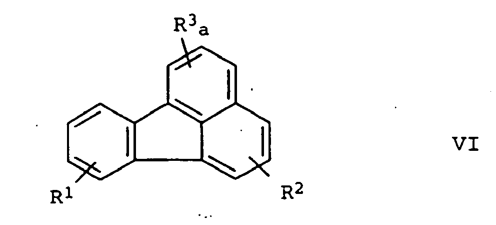 in denen mindestens einer, bevorzugt zwei der Reste R¹ bis R³ gewählt werden aus Y¹, wobei Y¹ gleich oder verschieden sind und gewählt aus -CH=CH₂, (E)- oder (Z)-CH=CH-C₆H₅, Acryloyl, Methacryloyl, α-Methylstyryl oder para-Methylstyryl, -O-CH=CH₂ oder Glycidyl, 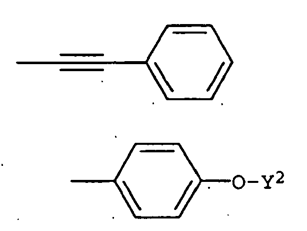 wobei Y² gewählt wird aus Acryloyl, Methacryloyl, α-Methylstyryl oder para-Methylstyryl,
-O-CH=CH₂ oder Glycidyl, und die übrigen Reste wie oben definiert sind, miteinander photochemisch oder thermisch polymerisiert. Vorzugsweise geht man so vor, dass man Monomere der Formel VI a 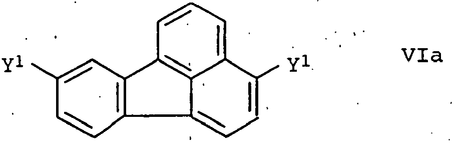 miteinander thermisch oder photochemisch polymerisiert oder copolymerisiert.

Eine thermische Polymerisation bzw. Copolymerisation führt man vorzugsweise so durch, dass man Monomere der allgemeinen Formel VI bzw. VI a, in denen mindestens einer, bevorzugt zwei der Reste R¹ bis R³ gewählt werden aus gut thermisch polymerisierbaren Resten Y¹, wobei gut thermisch polymerisierbare Reste Y¹ gleich oder verschieden sind und gewählt aus
(E)- oder (Z)-CH=CH-C₆H₅, α-Methylstyryl oder para-Methylstyryl, 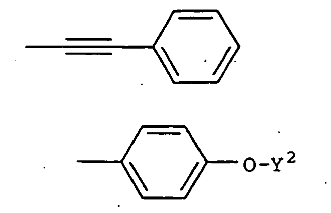 und Y² (E)- oder (Z)-CH=CH-C₆H₅, α-Methylstyryl oder para-Methylstyryl bedeutet, in Substanz oder als Lösung, gegebenenfalls mit Comonomeren, als Film aufträgt, vorzugsweise auf einer der Elektroden, und über einen Zeitraum von 10 Minuten bis 1 Stunden unter Stickstoff oder Edelgas erhitzt. Als vorteilhaft hat sich ein Temperaturbereich von 40 bis 120°C erwiesen. Dabei müssen optional anwesenden Comonomere ebenfalls pro Molekül mindestens eine, bevorzugt zwei der vorstehend beschriebenen gut thermisch polymerisierbaren Reste Y¹ tragen.

Eine photochemische Polymerisation bzw. Copolymerisation führt man vorzugsweise so durch, dass man Monomere der allgemeinen Formel VI bzw. VI a, in denen mindestens einer, bevorzugt zwei der Reste R¹ bis R³ gewählt werden aus gut photochemisch polymerisierbaren Resten Y¹, wobei gut photochemisch polymerisierbaren ResteY¹ gleich oder verschieden sein können und gewählt aus Acryloyl, Methacryloyl, -O-CH=CH₂ oder Glycidyl oder 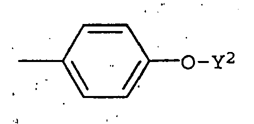 mit Y² gewählt aus Acryloyl, Methacryloyl, -O-CH=CH₂ oder Glycidyl, in Substanz oder in Lösung, gegebenenfalls mit Comonomeren, als Film aufträgt', vorzugsweise auf einer der Elektroden, und in Gegenwart eines gängigen Photoinitiators, der aus der Photopolymerisation von beispielsweise Acrylsäurederivaten oder Methacrylsäurederivaten oder ungesättigten Ethern bekannt ist, mit einer Strahlenquelle, beispielsweise einer UV-Lampe, belichtet. Dabei müssen optional anwesenden Comonomere ebenfalls pro Molekül mindestens einer, bevorzugt zwei der vorstehend beschriebenen gut photochemisch polymerisierbaren Reste Y¹ tragen.

Die Darstellung der Monomere der allgemeinen Formel VI bzw. VIa gelingt durch in Prinzip bekannte Reaktionen, die beispielsweise der Heck-Reaktion oder Stille-Kupplung ausgehend beispielsweise von Verbindungen der allgemeinen Formel IV, insbesondere IV a.1 bis IV a.4.

Die erfindungsgemäßen Polymere können Einheiten der allgemeinen Formel VII, bevorzugt VII a enthalten, 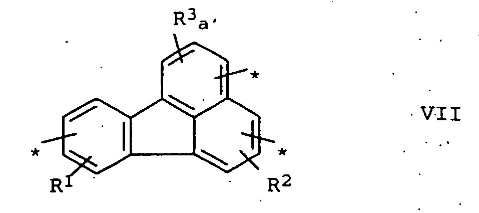 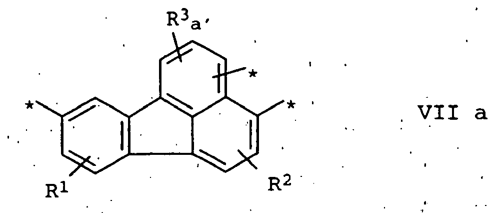 in denen a' eine ganze Zahl von 0 bis 2, bevorzugt 0 bis 1 und, besonders bevorzugt 0 ist und die übrigen Variablen wie vorstehend definiert sind. Polymere, enthaltend Monomereinheiten der Formel VII bzw. VII a kann man durch Zusetzen von beispielsweise Monomeren der Formel VIII a-d 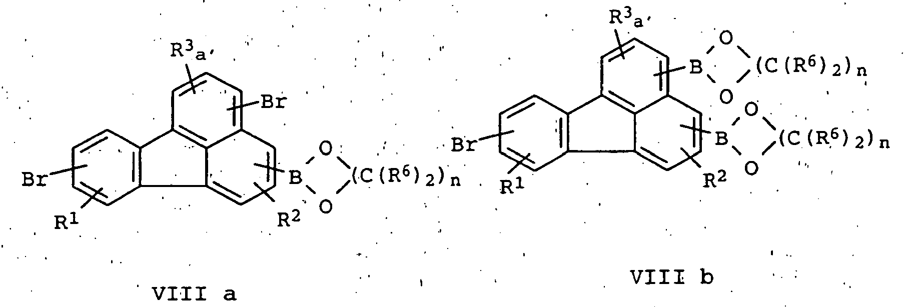 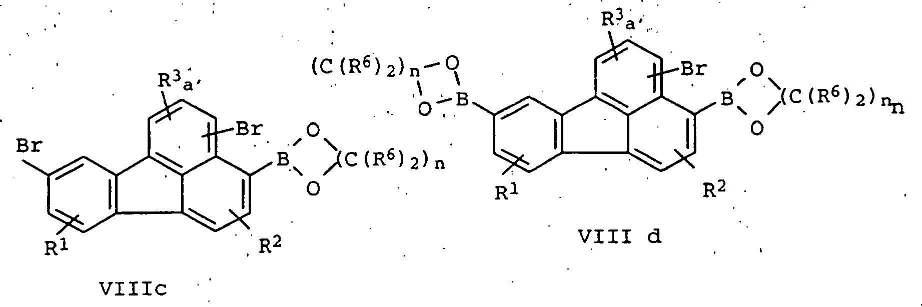 während der Palladium- oder Nickel-vermittelten Polymerisation der Monomere der allgemeinen Formel II bzw. II a synthetisieren.

Ein weiterer Aspekt der vorliegenden Erfindung ist die Verwendung der erfindungsgemäßen Polymere, enthaltend Wiederholungseinheiten der allgemeinen Formel I bzw. I a, zur Herstellung von organischen elektrolumineszierenden Dioden sowie organische elektrolumineszierende Dioden, hergestellt unter Verwendung der erfindungsgemäßen Polymere. Die erfindungsgemäßen organischen elektrolumineszierenden Dioden enthalten mindestens einen organischen Film, vorteilhaft mindestens zwei organische Filme, von denen mindestens einer elektrolumineszierende Eigenschaften hat und das erfindungsgemäße elektrolumineszierende Polymer enthält. Die erfindungsgemäßen organischen elektrolumineszierenden Dioden enthalten außerdem eine Kathode und eine Anode, die durch einen, besser mindestens zwei Filme separiert sind. Die Filme sind vorteilhaft nicht dicker als 0,1 µm. Vorteilhaft sind die zwei Elektroden aus unterschiedlichen Materialien, deren Leitungsband oder Valenzband dicht bei den Potenzialen der HOMO- und LUMO-Energieniveaus der erfindungsgemäßen Polymeren liegen. Mindestens eine der Elektroden - Kathode oder Anode - besteht aus einem Metallfilm oder einem Metalloxidfilm, der etwa 0,2 µm dick ist. Die erfindungsgemäßen elektrolumineszierenden Dioden lassen sich beispielsweise so herstellen, dass man zwischen einer Kathode und einer Anode einen Filmenthaltend oder bestehend aus den erfindungsgemäßen Polymeren, mit einer Dicke von 0,02 bis 0,2 µm appliziert. Eine andere Methode besteht darin, dass man einen oder mehrere Filme, von denen mindestens einer aus einem Polymer besteht, das ein oder mehrere erfindungsgemäße Polymere enthält, auf eine Elektrode appliziert und anschließend die zweite Elektrode anbringt. Eine der Elektroden ist optisch transparent.

Legt man nun ein elektrisches Feld oder eine elektrische Spannung an, so injiziert man Elektronen in das unterste unbesetzte Energieniveau (LUMO) oder Löcher in das oberste besetze Energieniveau (HOMO) des erfindungsgemäßen Polymers und erzielt Lichtemission durch die Rekombination der Ladungsträger.

Die Applikation der erfindungsgemäßen Polymeren erfolgt üblicherweise aus einer Lösung, wobei als organische Lösungsmittel beispielsweise Ether, chlorierte Kohlenwasserstoff wie beispielsweise Methylenchlorid und aromatische Kohlenwasserstoffe wie beispielsweise Toluol geeignet sind. Das Applizieren selber kann durch konventionelle Techniken erfolgen, beispielsweise filmbildendes Aufrakeln (Siebdrucktechnik), durch Auftragen mit einem Tintenstrahldrucker, durch Stempeldruck, beispielsweise durch PDMS, das ist Stempeldruck mittels Silikonkautschukstempel, der photochemisch strukturiert wurde.

Die erfindungsgemäßen elektrolumineszierenden Filme, welche die erfindungsgemäßen Polymere enthalten oder aus ihnen bestehen, sind üblicherweise 0,01 bis 0,4 µm dick, bevorzugt 0,05 bis 0,2 µm. Sie können weitere Bestandteile enthalten, die auf dem Gebiet der Herstellung organisch elektrolumineszierender Dioden allgemein üblich sind. Die erfindungsgemäßen Filme lassen sich zur Herstellung von organischen elektrolumineszierenden Dioden verwenden; diese zeigen gegenüber den aus dem Stand der Technik bekannten elektrolumineszierenden Dioden eine verlängerte Lebensdauer und weitere vorteilhafte Eigenschaften.

Die Erfindung wird durch Beispiele erläutert.

### Synthese von Verbindung III a.1

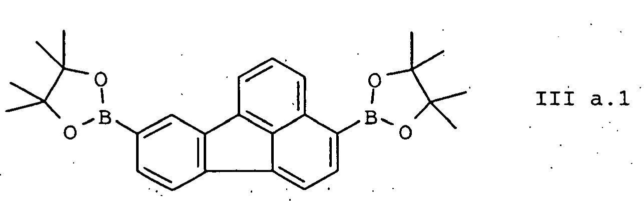

8 g 3,8-Dibromfluoranthen IV a.2, hergestellt durch zweifache Bromierung von Fluoranthen in Nitrobenzol, wurden unter Schutzgas in 90 ml THF gelöst und auf -5°C gekühlt. 61 ml tert.-Butyllithiumlösung (15 Gew.-% in Pentan) wurde zugetropft und 1,5 Stunden bei Raumtemperatur gerührt. 9,5 ml 2-Isopropoxy-4,4,5,5-tetramethyl-1,3,2-dioxaborolan wurden so zugetropft, dass die Temperatur 5 bis 20°C nicht überstieg. Die Reaktionsmischung wurde weitere 15 h bei Raumtemperatur gerührt. Das Reaktionsgemisch wurde auf Wasser gegossen und mehrfach (mindestens 3x) mit Diethylether extrahiert, die Etherphase nach Trocknung mit MgSO₄ eingeengt und an Kieselgel (Merck Kieselgel 60) chromatographisch gereinigt. Unpolare Verunreinigungen wurden mit Cyclohexan eluiert, das Produkt anschließend mit Essigsäureethylester/Cyclohexan (1:9 Volumenanteile) eluiert. Ausbeute: 50 % als gelber Feststoff. Die Struktur wurde durch ¹H-NMR-Spektrum bestätigt.

### Polymerisationsbeispiel

1,56 mmol 3,8-Dibromfluoranthen IV a.2, 1,58 mmol Fluoranthen-3,8-di(boronsäurepinakolylester) (Verbindung III a.1), 0,011 mmol Phasentransferkatalysator Aliquat® 336, kommerziell erhältlich bei Fa. Aldrich, sowie 2,5 ml 2 molare wässrige Natriumcarbonatlösung wurden mit 14 ml Toluol gemischt und mit Stickstoff entgast. 1,33 ml einer 0,1 Gew.-% Lösung von Tetrakis(triphenylphosphan)palladium in Toluol wurden zugegeben. Die Mischung wurde unter Argon 48 h bei 90 bis 100°C gehalten. Schließlich wurden 0,82 ml einer 1 Gew.-% Lösung von Brombenzol in Toluol zugegeben und weitere 24 h bei der gleichen Temperatur gerührt.

Zur Aufarbeitung wurde die Reaktionslösung in 50 ml einer verdünnten methanolischen HCl-Lösung getropft. Der ausgefallene Feststoff wurde abfiltriert, über Kieselgel (Merck Kieselgel 60, Laufmittel Toluol) gereinigt und in Methanol gefällt. Die Prozedur Ausfällen/Kieselgelreinigung wurde drei weitere Male wiederholt. Das Produkt fiel als gelbliches Pulver an.

## Patentansprüche

1. Polymere, enthaltend Wiederholungseinheiten der allgemeinen Formel I 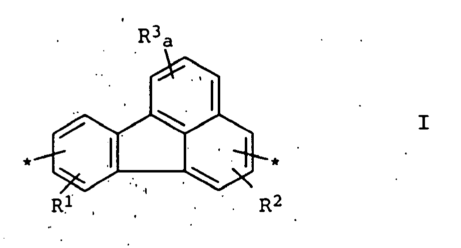 in denen die Variablen wie folgt definiert sind:
a eine ganze Zahl von 0 bis 3,
R¹, R², R³ gleich oder verschieden und unabhängig voneinander gewählt aus
Wasserstoff, C₁-C₂₀-Alkyl,
C₁-C₂₀-Alkyl, das ein oder mehrere Si, N, P, 0- oder S-Atome enthält, C₆-C₃₀-Aryl, bevorzugt C₆-C₁₄-Aryl, C₄-C₁₄-Heteroaryl mit mindestens einem S- öder N-Atom, -N(C₆-C₁₄-Aryl)₂,
Y¹, wobei. Y¹ gleich oder verschieden sein können und gewählt werden aus -CH=CH₂, (E)- oder (Z)-CH=CH-C₆H₅, Acryloyl, Methacryloyl, Methylstyryl, O-CH=CH₂ oder Glycidyl, 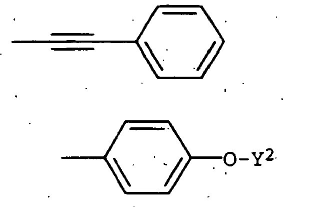
wobei Y² gewählt wird aus -CH=CH₂, (E)- oder (Z)-CH=CH-C₆H₅, Acryloyl, Methacryloyl, Methylstyryl, -O-CH=CH₂ oder Glycidyl und wobei eine oder mehrere Gruppen Y¹ oder Y² miteinander vernetzt sein können.

2. Polymere nach Anspruch 1, **dadurch gekennzeichnet, dass** sie Wiederholungseinheiten der allgemeinen Formel I a enthalten 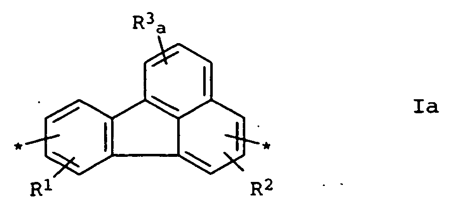 in denen a gleich 0 oder 1 ist und die übrigen Variablen wie oben stehend definiert sind.

3. Polymere nach Anspruch 1 oder 2, **dadurch gekennzeichnet, dass** sie zwischen 1 und 10 Wiederholungseinheiten der allgemeinen Formeln I oder I a enthalten.

4. Polymere nach einem der vorangehenden Ansprüche **dadurch gekennzeichnet, dass** a gleich 0 ist.

5. Polymere nach einem der vorangehenden Ansprüche, **dadurch gekennzeichnet, dass** sie 2 bis 4 Wiederholungseinheiten der allgemeinen Formel I oder I a enthalten.

6. Verfahren zur Herstellung von Polymeren gemäß einem der Ansprüche 1 bis 5, **dadurch gekennzeichnet, dass** man ein oder mehrere Monomere der allgemeinen Formel II 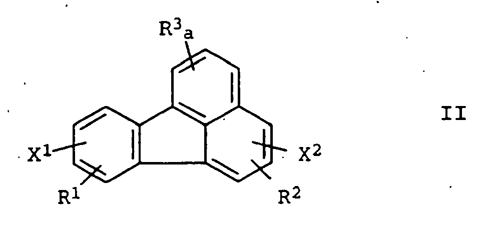
miteinander in Gegenwart einer Nickel- oder Palladiumverbindung umsetzt, wobei die Variablen R¹ bis R³ und a wie oben stehend definiert sind,
X¹ und X² gleich oder verschieden sind und gewählt aus
Halogen oder verestertes Sulfonat,
borhaltige Reste der Formel -B(O-[C(R⁶)₂]ₙ)-O), wobei
R⁶ gleich oder verschieden und unabhängig voneinander Wasserstoff oder C₁-C₂₀-Alkyl, n eine ganze Zahl von 2 bis 10 ist;
mit der Maßgabe, dass
man entweder ein Monomer der allgemeinen Formel II einsetzt und in diesem X¹ wählt aus Halogen und veresterem Sulfonat und X² aus borhaltigen Resten
oder dass man mindestens zwei verschiedene Monomere der allgemeinen Formel II einsetzt,
wobei ein Monomer zwei Halogen oder zwei veresterte Sulfonatgruppen oder ein Halogen und eine veresterte Sulfonatgruppe aufweist
und das andere Monomer zwei borhaltige Reste
-B(O-[C(R⁶)₂]ₙ)-O) aufweist
und das Molverhältnis aus der Summe von Halogen und verestertem Sulfonat einerseits und borhaltigen Resten anderseits zwischen 0,8 : 1 und 1,2 zu 1 liegt.

7. Verfahren nach Anspruch 6, **dadurch gekennzeichnet, dass** man ein oder mehrere Monomere der allgemeinen Formel II a 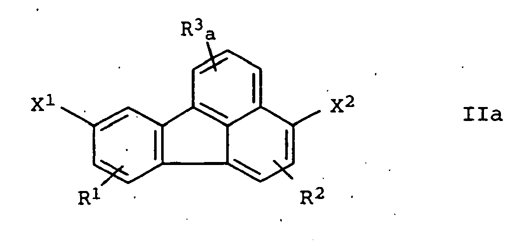 miteinander umsetzt.

8. Verfahren nach Anspruch 6 oder 7, **dadurch gekennzeichnet, dass** in Formel II a R¹ bis R³ jeweils Wasserstoff bedeuten.

9. Verfahren nach Anspruch 6 bis 8, **dadurch gekennzeichnet, dass** Pd in der Oxidationsstufe 0 vorliegt.

10. Monomere der allgemeinen Formel III 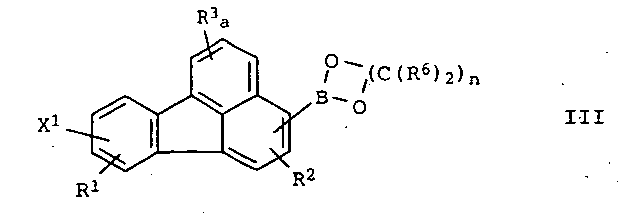
in denen die Variablen R¹ bis R³ und a wie oben stehend definiert sind,
X¹ gewählt wird aus Halogen oder verestertem Sulfonat oder
borhaltigen Resten der Formel -B(O-[C(R⁶)₂]ₙ)-O), wobei n eine ganze Zahl von 2 bis 10 ist.

11. Monomere der allgemeinen Formel III a 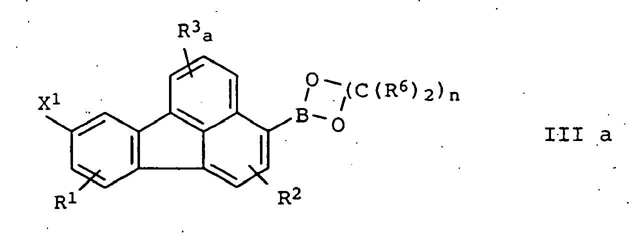 in denen die Variablen wie vorstehend definiert sind.

12. Verfahren zur Herstellung von Monomeren der allgemeinen Formel III, **dadurch gekennzeichnet, dass** man Verbindungen der allgemeinen Formel IV, 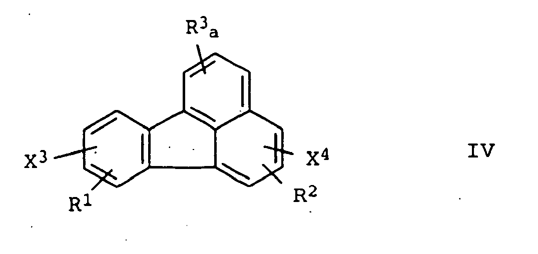 in denen X³ und X⁴ gleich oder verschieden sind und gewählt aus Halogen oder Sulfonat, mit mindestens zwei oder mindestens vier Äquivalenten einer starken metallorganischen Base metalliert und anschließend mit einem beziehungsweise 2 Äquivalenten einer Borverbindung der allgemeinen Formel V 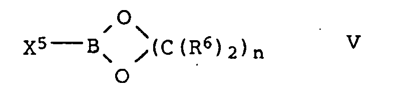 umsetzt, in der X⁵ gewählt wird aus C₁-C₆-Alkoxy.

13. Verfahren nach Anspruch 12, **dadurch gekennzeichnet, dass** man Verbindungen der allgemeinen Formel IV a. 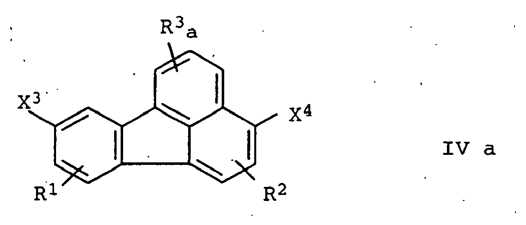 einsetzt.

14. Verfahren zur Herstellung von Polymeren nach einem der Ansprüche 1 bis 5, **dadurch gekennzeichnet, dass** man Monomere der allgemeinen Formel VI 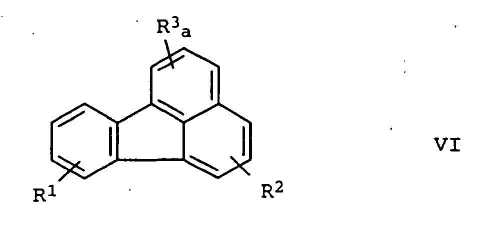 in denen mindestens 2 der Reste R¹ bis R³ jeweils Y¹ bedeuten und Y¹ gleich oder verschieden sind und gewählt werden aus -CH=CH₂, (E)- oder (Z)-CH=CH-C₆H₅, Acryloyl, Methacryloyl, α-Methylstyryl oder para-Methylstyryl, -O-CH=CH₂ oder Glycidyl, 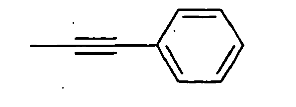 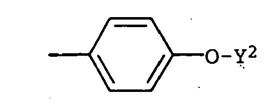 wobei Y² gewählt wird aus Acryloyl, Methacryloyl, α-Methylstyryl oder para-Methylstyryl, O-CH=CH₂ oder Glycidyl, miteinander photochemisch oder thermisch polymerisiert.

15. Verfahren nach Anspruch 14, **dadurch gekennzeichnet, dass** man Monomere der Formel VI a 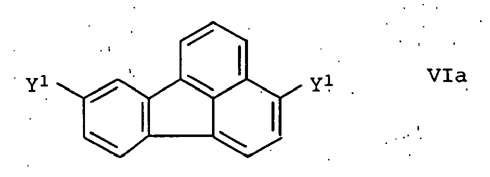 miteinander thermisch oder photochemisch polymerisiert.

16. Filme, enthaltend oder bestehend aus Polymeren nach den Ansprüchen 1 bis 5.

17. Verwendung von Polymeren nach einem der Ansprüche 1 bis 5 zur . Herstellung von organischen elektrolumineszierenden Dioden.

18. Organische elektrolumineszierende Dioden, hergestellt unter Verwendung von Polymeren nach einem der Ansprüche 1 bis 5.

## Claims

1. A polymer comprising repeating units of the formula I 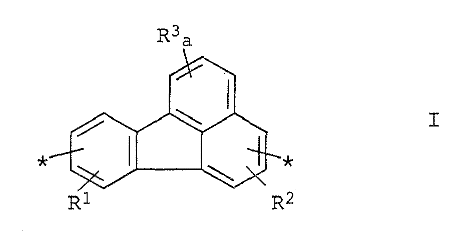 where the variables are defined as follows:
a is an integer from 0 to 3,
R¹, R², R³ are identical or different and are selected independently from among
hydrogen, C₁-C₂₀-alkyl,
C₁-C₂₀-alkyl comprising one or more Si, N, P, O or S atoms, C₆-C₃₀-aryl, preferably C₆-C₁₄-aryl, C₄-C₁₄-heteroaryl containing at least one S or N atom, -N(C₆-C₁₄-aryl)₂,
and Y¹, where Y¹ may be identical or different and are selected from among -CH=CH₂, trans- or cis- CH=CH-C₆H₅, acryloyl, methacryloyl, methylstyryl, O-CH=CH₂ and glycidyl, 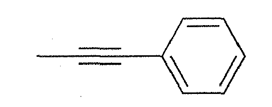 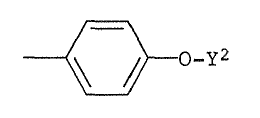
where Y² is selected from among -CH=CH₂, trans- or cis-CH=CH-C₆H₅, acryloyl, methacryloyl, methylstyryl, -O-CH=CH₂ and glycidyl, and one or more groups Y¹ or Y² may be crosslinked to one another.

2. The polymer according to claim 1 comprising repeating units of the formula I a 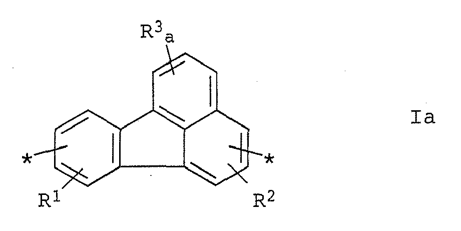 where a is 0 or 1 and the other variables are as defined above.

3. The polymer according to claim 1 or 2 comprising from 1 to 10 repeating units of the formula I or I a.

4. The polymer according to any of the preceding claims, wherein a is 0.

5. The polymer according to any of the preceding claims comprising from 2 to 4 repeating units of the formula I or I a.

6. A process for preparing polymers according to any of claims 1 to 5, which comprises reacting one or more monomers of the formula II 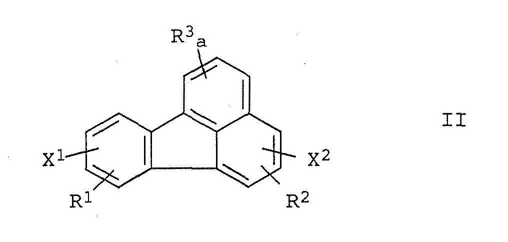
with one another in the presence of a nickel or palladium compound, where the variables R¹ to R³ and a are as defined above,
X¹ and X² are identical or different and are selected from among
halogen, esterified sulfonate and
boron-containing radicals of the formula -B(O-[C(R⁶)₂]ₙ)-O), where
R⁶ are identical or different and are each, depending on one another, hydrogen or C₁-C₂₀-alkyl, and n is an integer from 2 to 10;
with the proviso that
either a monomer of the formula II in which X¹ is selected from among halogen and esterified sulfonate and X² is selected from among boron-containing radicals is used
or at least two different monomers of the formula II
of which one monomer has two halogen or two esterified sulfonate groups or one halogen and one esterified sulfonate group
and the other monomer has two boron-containing radicals -B(O-[C(R⁶)₂]ₙ)-O) are used
and the molar ratio of the sum of halogen and esterified sulfonate to boron-containing radicals is from 0.8:1 to 1.2:1.

7. The process according to claim 6, wherein one or more monomers of the formula II a 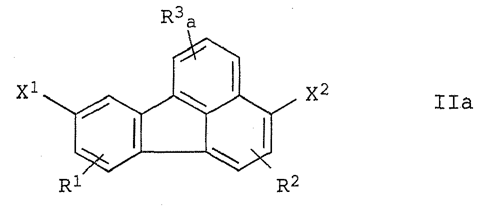 are reacted with one another.

8. The process according to claim 6 or 7, wherein R¹ to R³ in the formula II a are each hydrogen.

9. The process according to any of claims 6 to 8, wherein Pd is present in the oxidation state 0.

10. A monomer of the formula III 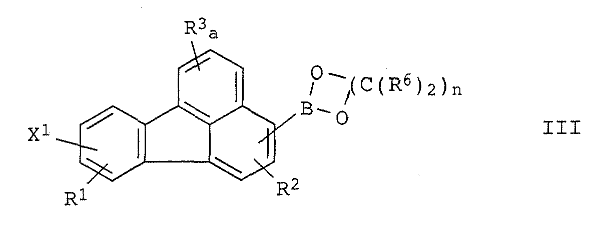
where the variables R¹ to R³ and a are as defined above and
X¹ is selected from among halogen and esterified sulfonate and boron-containing radicals of the formula -B(O-[C(R⁶)₂]ₙ)-O), where n is an integer from 2 to 10.

11. A monomer of the formula III a 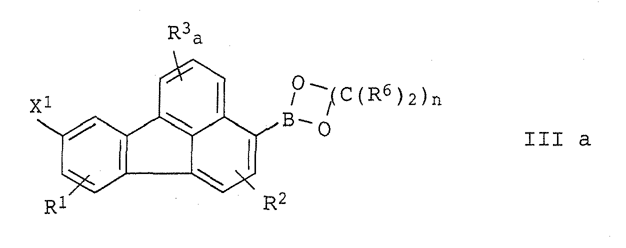 where the variables are as defined above.

12. A process for preparing monomers of the formula III, which comprises metalating compounds of the formula IV, 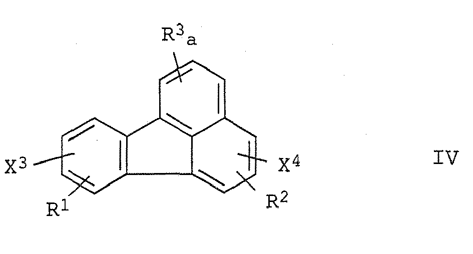 where X³ and X⁴ are identical or different and are selected from among halogen and sulfonate, by means of at least two or at least four equivalents of a strong organometallic base and subsequently reacting the product with one or two equivalents of a boron compound of the formula V 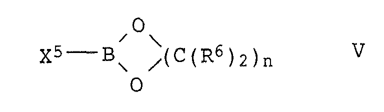 where X⁵ is selected from among C₁-C₆-alkoxy.

13. The process according to claim 12, wherein compounds of the formula IV a 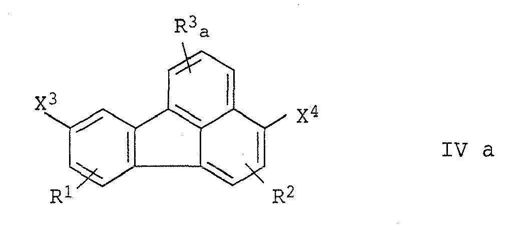 are used.

14. A process for preparing polymers according to any of claims 1 to 5, which comprises photochemically or thermally polymerizing monomers of the formula VI 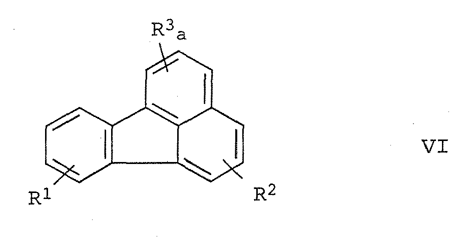 where at least 2 of the radicals R¹ to R³ are each Y¹ and Y¹ are identical or different and are selected from among -CH=CH₂, trans- or cis- CH=CH-C₆H₅, acryloyl, methacryloyl, α-methylstyryl and para-methylstyryl, -O-CH=CH₂ and glycidyl, 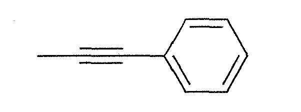 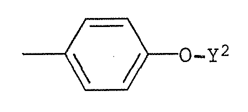 where Y² is selected from among acryloyl, methacryloyl, α-methylstyryl and para-methylstyryl, O-CH=CH₂ and glycidyl, with one another.

15. The process according to claim 14, wherein monomers of the formula VI a 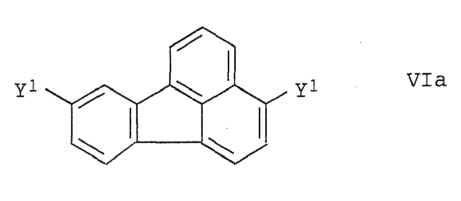 are thermally or photochemically polymerized with one another.

16. A film comprising or consisting of polymers according to any of claims 1 to 5.

17. The use of polymers according to any of claims 1 to 5 for producing organic electroluminescent diodes.

18. An organic electroluminescent diode produced using polymers according to any of claims 1 to 5.

## Revendications

1. Polymères contenant des unités répétitives de la formule générale I : 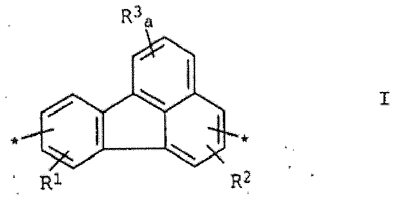 dans lesquelles les variables sont définies de la manière suivante :
a est un nombre entier de 0 à 3,
R¹, R², R³ sont identiques ou différents et sont, indépendamment les uns des autres, choisis parmi de l'hydrogène, ou un groupe alkyle en C₁-C₂₀, alkyle en C₁-C₂₀ qui contient un ou plusieurs atomes de Si, N, P, 0 ou S, aryle en C₆-C₃₀, de préférence aryle en C₆-C₁₄, hétéroaryle en C₄-C₁₄ comportant au moins un atome de S ou N, -N (C₆-C₁₄-aryle)₂,
Y¹, les Y¹ pouvant être identiques ou différents et choisis parmi des groupes -CH=CH₂, (E)- ou (Z) -CH=CH-C₆H₅, acryloyle, méthacryloyle, méthylstyryle, O-CH=CH₂ ou glycidyle, 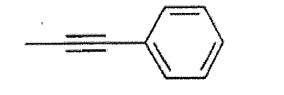 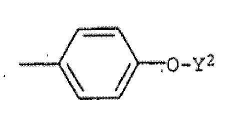
où Y² est choisi parmi des groupes -CH=CH₂, (E)- ou (Z) -CH=CH-C₆H₅, acryloyle, méthacryloyle, méthylstyryle, -O-CH=CH₂ ou glycidyle,
un ou plusieurs groupes Y¹ ou Y² pouvant être réticulés entre eux.

2. Polymères suivant la revendication 1, **caractérisés en ce qu'**ils contiennent des unités répétitives de la formule générale Ia : 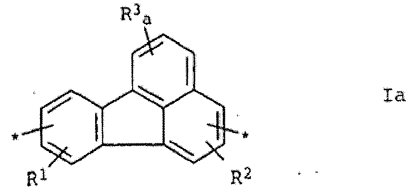 dans lesquelles a est égal à 0 ou 1 et les autres variables sont définies comme précédemment.

3. Polymères suivant la revendication 1 ou 2, **caractérisés en ce qu'**ils contiennent entre 1 et 10 unités répétitives de la formule générale I ou Ia.

4. Polymères suivant l'une des revendications précédentes, **caractérisés en ce que** a est égal à 0.

5. Polymères suivant l'une des revendications précédentes, **caractérisés en ce qu'**ils contiennent 2 à 4 unités répétitives de la formule générale I ou Ia.

6. Procédé de préparation de polymères suivant l'une des revendications 1 à 5, **caractérisé en ce qu'**on fait réagir entre eux un ou plusieurs monomères de la formule générale II : 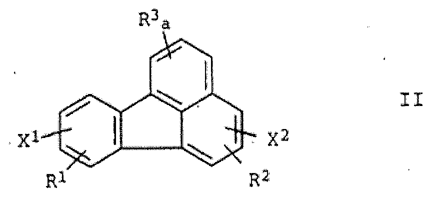
en présence d'un composé à base de nickel ou de palladium, les variables R¹ à R³ et a étant définies comme précédemment,
X¹ et X² étant identiques ou différents et choisis parmi
de l'halogène ou un sulfonate estérifié,
des radicaux à teneur en bore de la formule -B(O-[C(R⁶)₂]ₙ)-O), où R⁶ sont identiques ou différents et représentent indépendamment les uns des autres de l'hydrogène ou un groupe alkyle en C₁-C₂₀, n est un nombre entier de 2 à 10,
avec la condition qu'on met en oeuvre un monomère de la formule générale II et dans celle-ci on choisit X¹ parmi de l'halogène ou du sulfonate estérifié et X² parmi des radicaux à teneur en bore,
ou qu'on met en oeuvre au moins deux monomères différents de la formule générale II,
un monomère présentant deux halogènes ou deux groupes sulfonate estérifiés ou un halogène et un groupe sulfonate estérifié et l'autre monomère présentant deux radicaux à teneur en bore -B(O-[C(R⁶)₂]ₙ)-O),
et le rapport molaire entre la somme halogène et sulfonate estérifié, d'une part, et les radicaux à teneur en bore, d'autre part, étant compris entre 0,8/1 et 1,2/1.

7. Procédé suivant la revendication 6, **caractérisé en ce qu'**on fait réagir entre eux un ou plusieurs monomères de la formule générale IIa :

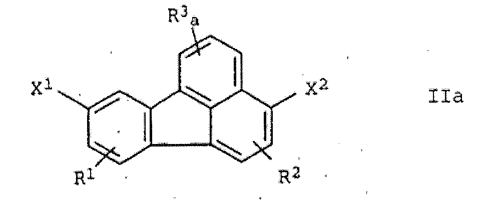

8. Procédé suivant la revendication 6 ou 7, **caractérisé en ce que**, dans la formule IIa, R¹ à R³ représentent chacun de l'hydrogène.

9. Procédé suivant d'une des revendications 6 à 8, **caractérisé en ce que** Pd se présente dans le degré d'oxydation 0.

10. Monomères de la formule générale III : 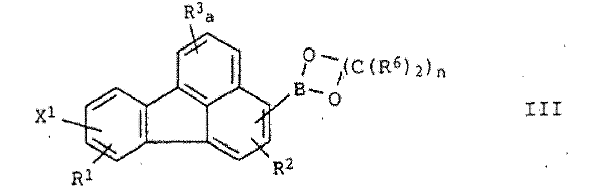
dans lesquels les variables R¹ à R³ et a sont définies comme précédemment,
x¹ est choisi parmi de l'halogène ou du sulfonate estérifié ou des radicaux à teneur en bore de la formule -B(O-[C(R⁶)₂)ₙ)-O), où n est un nombre entier de 2 à 10.

11. Monomères de la formule générale IIIa : 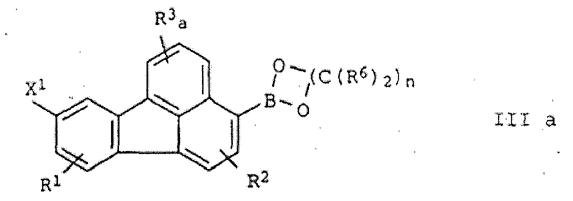 dans lesquels les variables sont telles que définies précédemment.

12. Procédé de préparation de monomères de la formule générale III, **caractérisé en ce qu'**on métallise des composés de la formule générale IV : 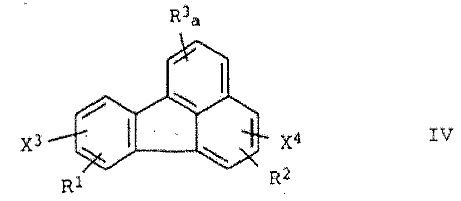 dans lesquels X³ et X⁴ sont identiques ou différents et choisis parmi de l'halogène ou du sulfonate, avec au moins deux ou au moins quatre équivalents d'une base organométallique forte et **en ce qu'**on fait ensuite réagir avec un ou respectivement deux équivalents d'un composé de bore de la formule générale V : 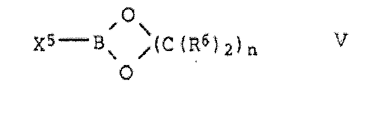 dans laquelle X⁵ est choisi parmi des alcoxy en C₁-C₆.

13. Procédé suivant la revendication 12, **caractérisé en ce qu'**on met en oeuvre des composés de la formule générale IVa :

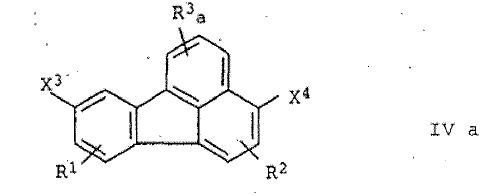

14. Procédé de préparation de polymères suivant l'une des revendications 1 à 5, **caractérisé en ce qu'**on polymérise mutuellement par voie photochimique ou thermique des monomères de la formule générale VI : 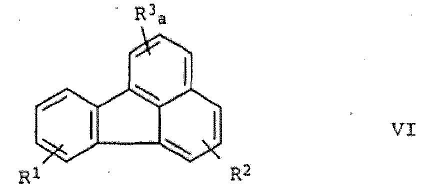 dans lesquels au moins deux des radicaux R¹ à R³ représentent chacun Y¹ et les Y¹ sont identiques ou différents et choisis parmi des groupes -CH=CH₂, (E)- ou (Z) .CH=CH-C₆H₅, acryloyle, méthacryloyle, α-méthylstyryle ou para-méthylstyryle, -O-CH=CH₂ ou glycidyle, 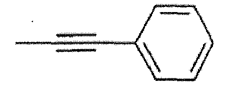 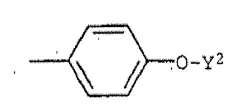 Y² étant choisi parmi des groupes acryloyle, méthacryloyle, α-méthylstyryle ou para-méthylstyryle, O-CH=CH₂ ou glycidyle.

15. Procédé suivant la revendication 14, **caractérisé en ce qu'**on polymérise entre eux par voie thermique ou photochimique des monomères de la formule VIa :

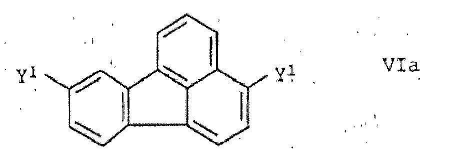

16. Films contenant des ou constitués de polymères suivant les revendications 1 à 5.

17. Utilisation de polymères suivant l'une des revendications 1 à 5, pour la préparation de diodes électroluminescentes organiques.

18. Diodes électroluminescentes organiques, préparées par utilisation de polymères suivant l'une des revendications 1 à 5.
